# EUROPEAN PATENT APPLICATION

(11) **EP 4 521 444 A1**
(43) Date of publication of application: **12.03.2025**
(21) Application number: 23196108.7
(22) Date of filing: 07.09.2023
(51) Int. Cl.: H01J 37/147, H01J 37/28

(54) **SYSTEM AND METHOD FOR DEFLECTING A BEAM OF CHARGED PARTICLES**

(71) Applicant: The Provost, Fellows, Scholars and other Members Of the Board of Trinity College Dublin, D02 PN40 Dublin (IE)
(72) Inventor: JONES, Lewys, Dublin, D02 PN40 (IE); PETERS, Jonathan, Dublin, D02 PN40 (IE)
(74) Representative: Warren, Caroline Elisabeth

(57) **Abstract**

There is described a deflector system for a charged particle instrument, the system comprising a first deflector set configured to generate a first electromagnetic field for deflecting a beam of charged particles with a first response rate, a second deflector set configured to generate a second electromagnetic field for deflecting the beam of charged particles with a second response rate, and a controller configured to drive the first deflector set for a driving time period and drive the second deflector set during the driving time period to control the beam of charged particles to move across a target area. The system can enable more accurate control of a beam of charged particles and enable faster beam scanning at lower magnifications. There is also described a method for controlling such a deflector system, which in some embodiments may include determining input profiles for the first and second deflector sets based on control data indicative of a scanning pattern.

## Description

### FIELD OF THE INVENTION

The present application relates to deflector systems for controlling a beam of charged particles, and methods for controlling such systems. In particular, the application relates to deflector systems that use sets of electromagnetic deflectors to move a beam of charged particles across a target area.

### BACKGROUND OF THE INVENTION

In various charged-particle systems, a beam of charged particles (e.g. a beam of electrons or ions) is moved across a target area according to a particular pattern. For example, in instruments which form an image of a specimen at the target area, the beam may be deflected such that it traverses a surface of the specimen in a raster scanning pattern (line-by-line). Typically, the beam is deflected using a time-varying electromagnetic field that is generated by modulating a current through a set of wire coils.

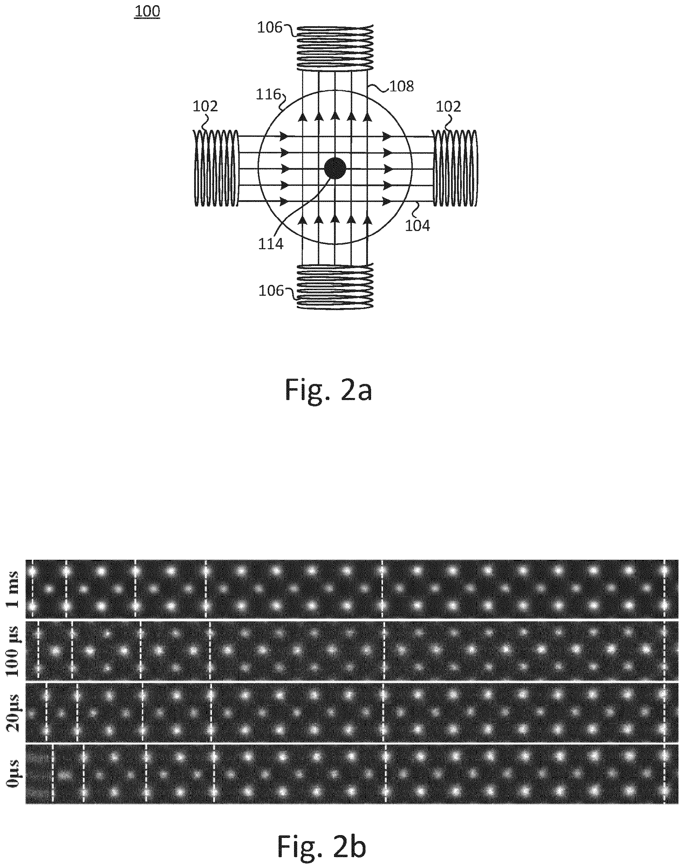

In order to achieve greater deflections to scan the beam over larger areas, the coils need to generate a stronger electromagnetic field. However, since the inductance of wire coils (i.e. their tendency to oppose a change in electric current) scales with the number of coils turns, the current in larger, more powerful coils cannot be modulated as quickly. Thus, these existing deflectors suffer from reduced scanning speeds when used for scanning larger areas (at lower magnifications). In addition, the coils have an inductance-limited speed, so driving the coils faster in the hope of achieving faster scanning will risk inducing hysteresis which, for example, can result in non-linear warping of a captured image (as illustrated in Figure 2b).

Some attempts have been made to address these warping effects by introducing a "flyback" waiting or settling time, for example at the start of each new scan line in a raster scanning pattern. However, for larger scan areas, this settling time can be unacceptably long, resulting in impractical overall scanning speeds. This is particularly undesirable when scanning biological specimens since the slower scanning speed can result in higher radiation doses.

Further attempts to circumvent the issues described above include using smaller coils to achieve faster scanning of small areas (at high magnifications), and then successively repositioning the beam to scan new, small areas. However, this only improves the scanning speed at high magnifications, and still results in a low overall scanning speed.

### SUMMARY OF THE INVENTION

Aspects of the invention are set out in the independent claims and preferable features are set out in the dependent claims.

There is described herein a deflector system for a charged particle instrument, the system comprising:
a first deflector set configured to generate a first electromagnetic field for deflecting a beam of charged particles with a first response rate;
a second deflector set configured to generate a second electromagnetic field for deflecting the beam of charged particles with a second response rate; and
a controller configured to drive the first deflector set for a driving time period and drive the second deflector set during the driving time period to control the beam of charged particles to move across a target area.

By driving the first deflector set for a driving time period and a second deflector set during that time period, the two deflector sets are driven simultaneously for at least part of the driving time period. This can improve the overall response rate of the deflector system, allowing the beam of charged particles to be controlled more accurately, for example with respect to a target scanning pattern.

Controlling the beam to move across the target area in this manner can enable the beam (or a focus point of the beam) to be scanned across or otherwise dynamically traverse the target area according to any pattern or path. For example, moving the beam across the target area can include covering substantially all of the target area with the beam. The target area may include a material or specimen to be scanned, imaged, constructed and/or destroyed. The beam of charged particles may be a beam of electrons or a beam of ions, such as helium ions.

The term "deflector set" as used herein refers to a set of one or more deflectors that are configured to deflect a beam of charged particles. For example, a single deflector may be any component arranged to generate a field for deflecting charged particles, such as an electromagnetic deflector (e.g. scanning coils) or an electrostatic deflector (e.g. electrostatic deflector plates). Accordingly, a deflector set can include any number of such deflectors, such one or more deflectors or one or more pairs of deflectors, that are controlled together in a coordinated manner. For example, a deflector set may include one or more deflectors responsible for deflection in a first direction (e.g. x-direction) and one or deflectors responsible for deflection in a second direction (e.g. y-direction). In some embodiments, a deflector set includes two pairs of scanning coils, one pair arranged to control x-direction deflections and the other pair arranged to control y-direction deflections.

The term "electromagnetic field" as used herein refers to any electric and/or magnetic field, such as a magnetic field, an electrostatic field, or both. In general the electromagnetic fields generated by the deflector sets described herein are time-varying in order to control a beam of charged particles to move.

The term "response rate" as used herein refers to a speed with which a deflector set generates an output electromagnetic field or causes a deflection in response to a target electromagnetic field or target deflection. A faster response rate indicates that a deflector set is able to produce faster deflections of a beam, and for example conform to a target scanning pattern more quickly. For example, a response rate can include a period of time, a rate of change, an acceleration and/or a frequency with which the output of a deflector set responds to an input.

The term "drive" as used herein refers to the control of deflector sets in a targeted or coordinated manner. For example, "driving" a deflector set may also be referred to as energising, activating or any other type of controlling, and driving a deflector set can include controlling the deflector set according to a control or input profile, e.g. from an initially powered or unpowered state.

The driving of deflector sets "simultaneously" as used herein refers to driving the deflector sets at least partially at the same time, at least partially concurrently and/or with overlapping use or activations times.

The controller may be configured to drive the first and second deflector sets to scan the beam across the target area at a substantially constant frame rate for a range of magnifications between around 50,000 and 50,000,000. This can enable images of at least a portion of the target area to be produced at a constant (higher) frame rate across a range (preferably the whole range) of available magnifications in a given instrument in a single mode of operation. The frame rate may be at least 15 frames per second. The range of magnifications may be between around 100,000 and 10,000,000.

The controller may be configured to scan the beam such that a position of the beam remains within a threshold deviation of a target scanning pattern for at least 80% of the driving time period. The threshold deviation may be around a 10% deviation. The beam may be scanned such that it remains within the threshold deviation for at least 90% or at least 95% of the driving time period. The target area may comprise a dimension of at least 2 nm. The target area may comprise a dimension of at least 2 mm. The dimension can include one or more of a width, length, diameter, perimeter, diagonal and/or field-of-view of the target area. The deflectors, when activated simultaneously by the controller, may be configured to scan the beam of charged particles at the target area across a distance of at least 2 nm in no more than 300 µs.

In the embodiments described herein, the response rates of the deflector sets may be different. The second response rate may be greater than the first response rate. This can enable the second deflector set to compensate for a slower response rate of the first deflector set. The first deflector set may have a first inductance and the second deflector set may have a second inductance that is lower than the first inductance. A ratio of the first inductance to the second inductance may be at least around 2, preferably between 5 and 10. Each of the first and second deflector sets may comprise an electromagnetic deflector set comprising one or more, preferably two, pairs of scanning coils. Each coil of the first deflector set may have a first number of turns and each coil of the second deflector set may have a second number of turns that is less than the first number of turns. A ratio of the first number of turns to the second number of turns may be at least around 2, preferably between 5 and 10. By having a lower inductance (e.g. fewer coil turns), the second deflector set can achieve a lower response rate for improving the overall response rate of the deflector system.

The system may further comprise at least one further deflector set configured to generate an additional electromagnetic field for deflecting the beam of charged particles with a response rate. This can allow the overall performance or response rate of the deflector system to be improved further. The response rate of the further deflector set may be greater than the first and/or second response rates. The at least one further deflector set may have an inductance which is less than an inductance of the first deflector set and/or the second deflector set. A ratio of the inductance of the second deflector set to the inductance of the further deflector set may be at least around 2. The further deflector set may comprise an electromagnetic deflector set comprising one or more, preferably two, pairs of scanning coils. Each coil of the further deflector set may have a number of turns that is less than the first and/or second number of turns. A ratio of the second number of turns (of the second deflector set coils) to the number of turns of the coils of the further deflector set may be at least around 2, preferably between 5 and 10.

Each of the deflector sets may have different inductances. At least one of the deflector sets may comprise an electrostatic deflector set comprising one or more pairs of deflector plates.

At least one of the deflector sets may comprise an electromagnetic deflector set comprising one or more, preferably two, pairs of scanning coils. The pair(s) of scanning coils may provide a beam opening therebetween for receiving the beam of charged particles, and each pair of scanning coils may be arranged to generate an electromagnetic field across the beam opening. The pair(s) of scanning coils may be positioned around or may surround the beam opening. The beam opening may be configured to receive at least a portion of a beam of charged particles or a beam path.

The pairs of coils for each deflector set may be arranged substantially perpendicularly around the beam opening. The term "substantially perpendicularly" refers to the pairs of coils being aligned at approximately right angles to the other pair(s) of coils of a given deflector set, or along corresponding axes such that the fields generated by each pair of coils are approximately perpendicular (or at least non-parallel). Alternatively, the coil pairs of a deflector set may be aligned along any other non-parallel (and coplanar) axes. Each deflector set may comprise an electromagnetic deflector set, and each pair of coils of the second deflector set may be aligned with a corresponding pair of coils of the first deflector set or the coils of the second deflector set may be angularly offset from the coils of the first deflector set. The pairs of coils of the first and second deflector sets may be aligned such that the electromagnetic fields generated by the deflector sets are substantially coincident and/or coplanar. The coils of the second deflector set may be angularly offset from the coils of the first deflector set by between 0° and 90°, optionally by around 30° or by around 45°.

The controller may be configured to drive the deflector sets independently from one another. The controller may be configured to drive the deflector sets with different input profiles. The term "input profile" as used herein refers to a signal shape, waveform or other information that is used as input for controlling (the deflectors of) the deflector sets. For example, the input profile for a deflector set may be used to modulate the input voltages or currents. An input profile can include data (e.g. waveform data) indicative of how the inputs (e.g. voltage or current levels) of the deflectors of the respective deflector set are to be controlled. For example, if a deflector set has two pairs of scanning coils, the input profile may include separate input (e.g. voltage or current) profiles with which to drive each coil pair.

The controller may be configured to scan the beam of charged particles across the target area according to a predetermined scanning pattern. The scanning pattern may comprise one or more of: a raster scanning pattern, a serpentine pattern, a spiral pattern, a square pattern, a round pattern, a Hilbert scanning pattern, a Lissajous scan and/or a sparse, vector and/or leapfrog scan coordinate set. The controller may be further configured to receive control data indicative of a scanning pattern, and modulate an input profile for each deflector set based on the control data to control the deflector sets to generate a combined electromagnetic field that deflects the beam across the target area according to the scanning pattern.

The system may further comprise a charged particle source configured to generate the beam of charged particles. The system may further comprise a detector configured to detect charged particles emitted or emergent from a specimen at the target area. The detected particles emitted or emergent from the target area may be the same or different from the charged particles in the deflected beam. For example, the detected particles may include sputtered particles from the specimen, such as electrons or ions, and/or secondary electrons emitted from the specimen. The deflector sets may be positioned at substantially the same location along a beam path from the charged particle source to the detector.

There is also described herein a system for deflecting a beam of charged particles, the system comprising:
two or more electromagnetic deflector sets each configured to generate an electromagnetic field with a respective response rate; and
a controller configured to drive the deflector sets substantially simultaneously during a driving time period to scan a beam of charged particles across a target area at a substantially constant frame rate for a range of magnifications between around 50,000 and 50,000,000.

The controller may be configured to drive the deflector sets at the substantially constant frame rate across the range of magnifications in a single mode of operation. The range of magnifications may be between around 100,000 and 10,000,000.

The frame rate may be at least around 15 frames per second. The frame rate may be at least around 25 frames per second. The controller may be configured to scan the beam such that a position of the beam remains within a threshold deviation of a target scanning pattern for at least 80%, preferably at least 90% or at least 95%, of the driving time period. The threshold deviation may be at least a 1% deviation, around 5% or 10% deviation, or no more than around 15% deviation.

The response rates of the deflector sets can be the same or different. Where the response rates of the deflector sets are the same, a second deflector set may be driven with half of the current used to drive a first deflector set.

There is also described herein an instrument for imaging a specimen or for forming a pattern on a specimen, the instrument comprising one or more of any deflector system described herein, wherein the one or more deflector systems are configured to move a beam of charged particles across a target area comprising at least a portion of the specimen.

Where the instrument is for forming a pattern on a specimen, the instrument may be for removal and/or addition of material at the target area. The instrument may be for deposition, ablation, sketching, etching, electron beam lithography, sputtering and/or three-dimensional printing. The instrument may comprise at least two deflector systems. This can enable variable control of both the position and tilt of the beam of charged particles at the target area.

The one or more deflector systems may be configured to scan the beam across the target area at a rate of at least 15 frames per second, or at least 25 frames per second. The instrument may be for imaging the specimen and the target area may define a field-of-view of at least 2 nm and/or an image frame size of at least 512 pixels by 512 pixels. The instrument may be configured, when the deflector sets of the one or more deflector systems are driven simultaneously by the controller, to capture images of the specimen at a frame rate of at least around 15 frames per second or at least around 25 frames per second, optionally at magnifications of less than or equal to around 1,000,000 or less than or equal to around 100,000.

The instrument may comprise one or more of: a scanning electron microscope, SEM; a scanning transmission electron microscope, STEM; a scanning helium ion microscope, SHIM; a focussed ion beam, FIB, instrument; an electron beam lithography, EBL, instrument; and/or an electron beam three-dimensional printer.

There is also described herein a method controlling any deflector system described herein, the method comprising driving a first deflector set for a driving time period and driving a second deflector set during the driving time period to control a beam of charged particles to move across a target area.

By driving the second deflector set during the driving time period of the first deflector set, the overall response rate when controlling a beam of charged particles can be improved, providing more accurate and dynamic control.

The method may further comprise the steps of: obtaining an input profile for each of the first deflector set and the second deflector set; and modulating an input current of the first and second beam deflector sets based on the input profiles. The input profile for the second deflector set may be faster than the input profile for the first deflector set for at least some of the driving time period. This can counteract or compensate for the errors of the first deflector set using the second deflector set, enabling more accurate beam motion. The input profile for the first deflector set may comprise a maximum frequency that is lower than that of the input profile for the second deflector set.

The step of obtaining the input profiles may comprise: receiving control data indicative of a scanning pattern for scanning the beam across the target area; and determining an input profile for each of the first deflector set and the second deflector set based on the control data. Driving the first and second deflector sets may comprise scanning the beam of charged particles across the target area according to the scanning pattern. Determining the input profiles for the first and second deflector sets may be further based on inductances of the first and second deflector sets. The input profiles may be determined such that the first deflector set is controlled to perform slower or lower-frequency scanning, and the second deflector set is controlled to performed faster or higher-frequency scanning.

The step of determining the input profiles may comprise: determining the input profile for the first deflector set based on the control data indicative of the scanning pattern; determining an output scanning profile of the first deflector set in response to the input profile for the first deflector set; calculating an error profile between the output scanning profile of the first deflector set and the input profile for the first deflector set; and determining the input profile for the second deflector set based on the calculated error profile. Determining the output scanning profile of the first deflector set may include measuring, calculating, predicting and/or inferring the output scanning profile of the first deflector set. By calculating, predicting and/or inferring the output scanning profile, the input profile for the second deflector can be determined without running the first deflector set first, allowing for unseen scanning patterns to be implemented on-the-fly. The input profile for the second deflector set may comprise an additive inverse of the error profile. This can allow the control of the second deflector set to be tuned to more accurately compensate for the errors of the first deflector set.

Any system feature as described herein may also be provided as a method feature, and vice versa. As used herein, means plus function features may be expressed alternatively in terms of their corresponding structure.

Any feature in one aspect of the invention may be applied to other aspects of the invention, in any appropriate combination. In particular, method aspects may be applied to system aspects, and vice versa. Furthermore, any, some and/or all features in one aspect can be applied to any, some and/or all features in any other aspect, in any appropriate combination.

It should also be appreciated that particular combinations of the various features described and defined in any aspects of the invention can be implemented and/or supplied and/or used independently.

### BRIEF DESCRIPTION OF THE FIGURES

Systems and methods for deflecting a beam of charged particles are described by way of example only, in relation to the Figures, wherein:
Figures 1a-1b show schematic diagrams of example charged-particle instruments;
Figures 2a-2b show (a) a sectional diagram of a deflector system and a beam of charged particles, and (b) example images captured using different line flyback times;
Figures 3a-3b show sectional diagrams of deflector systems having (a) two sets of deflectors and (b) three sets of deflectors;
Figures 4a-4d show diagrams of different deflector system arrangements;
Figures 5a-5e show diagrams of (a) the control flow within a deflector system and (b)-(e) methods for controlling a deflector system;
Figures 6a-6c show plots of control signals and scanning errors for (a) a first deflector set, (b) a second deflector set and (c) a third deflector set based on a sawtooth target scanning pattern; and
Figures 7a-7b show plots of (a) the scanning error and (b) a percentage on unusable scanning time for different deflector systems.

### DETAILED DESCRIPTION

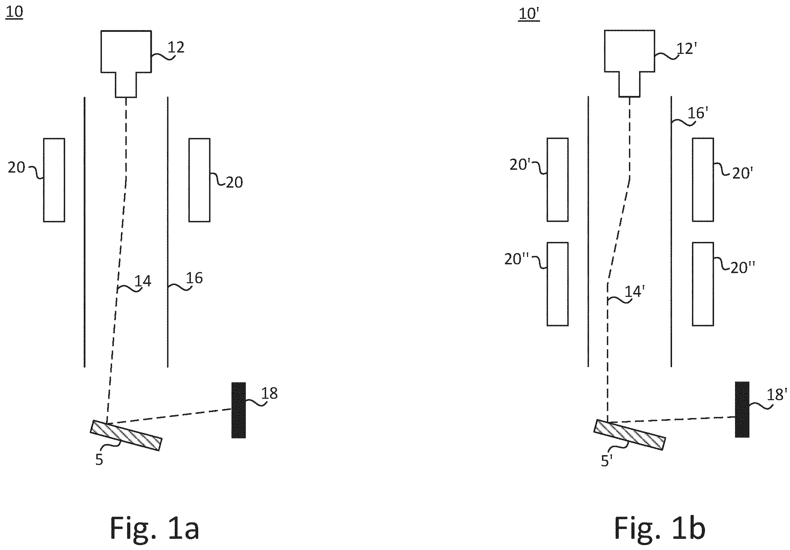

Referring to Figure 1a, an example charged-particle instrument 10 will now be described. The instrument 10 includes a source 12 configured to emit a beam 14 of charged particles, such as electrons or ions (e.g. helium ions), towards a target area 5 along a beam path. The beam 14 extends along beam path from the source 12 of charged particles, through a beam column 16, and towards the target area 5. A specimen to be imaged or to have material added or removed (e.g. by ablation, etching, sputtering etc.) may be located at the target area 5.

In some examples, the instrument 10 is an imaging instrument, such as a scanning electron microscope (SEM), a scanning transmission electron microscope (STEM), a scanning helium ion microscope (SHIM) or a focussed ion beam (FIB) instrument. In such cases, the specimen at the target area 5 is a specimen to be imaged, and the instrument 10 includes a detector 18 configured to detect particles emergent or emitted from the target area 5. For example, the particles detected by the detector 18 may be charged particles (e.g. electrons or ions) originating from the charged particle source 12 that have deflected off the surface of the specimen; additionally or alternatively, the detected particles may be secondary electrons or sputtered material of the specimen (e.g. ions) emitted as a result of the beam 14 colliding with the specimen.

In some examples, the instrument 10 is used for forming a pattern in a specimen at the target area 5 or for depositing material at the target area 5. For example, the instrument 10 may be a focussed ion beam (FIB) instrument, an electron beam lithography (EBL) instrument or an electron beam three-dimensional printer.

The instrument 10 also includes at least one deflector system 20 for deflecting the beam 14 of charged particles. The deflector system 20 is typically positioned adjacent the beam column 16, for example around the column. The deflector system 20 is configured to generate an electromagnetic (e.g. magnetic or electrostatic) field at a region along the beam path, which causes the beam 14 of charged particles to be deflected in a corresponding direction, as shown in Figure 1a. As described in greater detail below, the deflector system 20 includes at least two sets of deflectors (e.g. each including one or more pairs of wire coils or electrostatic deflector plates), each deflector set configured to generate its own electromagnetic field in response to a driving input. The deflector system 20 also includes a controller (not shown) configured to drive the deflector sets in a coordinated and substantially simultaneous manner. The deflector sets are driven according to time-varying inputs to generate time-varying electromagnetic fields in order to dynamically control the position of the beam 14 to move across the target area 5 according to a particular pattern. For example, the deflector system 20 may deflect the beam 14 across the surface of a specimen at the target area 5 (or at least a portion thereof) in a raster scanning pattern (or any other suitable pattern), causing the same or other particles to be emitted from the specimen and detected by the detector 18, enabling an image of the specimen to be constructed.

A second example charged-particle instrument 10' is shown in Figure 1b. Unless stated otherwise, similar reference numerals (indicated with ') are used in Figure 1b to denote corresponding features from the instrument 10 of Figure 1a. In some examples, the instrument 10' is a development of the instrument 10 of Figure 1a. In particular, the instrument 10' includes a source 12' configured to emit a beam 14' of charged particles towards a target area 5' along a beam path and through a beam column 16'.

The instrument 10' includes a first deflector system 20', which corresponds to the deflector system 20 of the instrument 10. However, the instrument 10' differs from instrument 10 in that it includes a second deflector system 20". Similarly to the first deflector system 20', the second deflector system 20" is configured to generate an electromagnetic field at a region (different from the region acted on by the first deflector system 20') along the beam path. The first and second deflector systems 20', 20" allow for independent and variable control of the position and tilt of the beam 14' (e.g. at the target area 5'). For example, as shown in Figure 1b, the first deflector system 20' generates a field to apply an initial deflection to the beam 14', and the second deflector system 20" can generate an equal and opposite field such that the beam 14' is re-straightened (un-tilted) but translated.

In some examples, an additional pair of first and second deflector systems (sometimes referred to as "de-scan" coils) can be provided between the target area and the detector to un-deflect or un-tilt the beam of particles emitted from the specimen such that they are incident at substantially the same location on the detector during scanning.

Figure 2a shows an example conventional deflector system 100 according to an existing configuration. In some examples, the deflector system 100 corresponds to one or more of the deflector systems 20, 20', 20" described above. The deflector system 100 includes a first pair of coils 102 and a second pair of coils 106. The coils 102 are coupled and configured to generate an electromagnetic field 104 therebetween in response to an input signal (voltage). Similarly, the coils 106 are coupled and configured to generate an electromagnetic field 108 therebetween in response to an input signal (voltage). The pairs of coils 102, 106 are arranged to generate the electromagnetic fields 104, 108 across the beam column 116 such that the beam 114 of charged particles passes through the fields 104, 108.

The view in Figure 2a is a sectional view across the path of a beam of charged particles, and accordingly the pairs of coils 102, 106 in this example are positioned at the same location along the beam path such that the fields 104, 108 combine to produce a combined overall electromagnetic field. In other examples, the first pair of coils 102 may be positioned at a different location along the beam path than the second pair of coils 106.

In this example, the coils 102, 106 have the same properties (e.g. number of turns, wire thickness, wire material) such that both pairs of coils 102, 106 have the same response to a given input signal. The pairs of coils 102, 106 form a set of deflectors (of a first type) and may be collectively referred to as a deflector set. Equally, the pairs of coils 102, 106 are orientated differently around an opening for the beam path, for example the second pair of coils 106 is angularly offset from the first pair of coils 102 by 90°. Accordingly, the magnitude and direction of the fields 104, 108 generated by the pairs of coils can be controlled to deflect the beam 114 in any direction. For example, where the pairs of coils 102, 106 are offset by 90° from one another, they may be used to independently control deflection of the beam along orthogonal axes (e.g. x- and y-axes).

The deflector system 100 also includes a controller (not shown) coupled to the coil pairs 102, 106 and configured to modulate an input profile (e.g. voltage or current profile) of each coil pair 102, 106 in order to cause the electron beam to scan across a target area according to a predetermined pattern.

In one example, as shown in Figure 2b, the deflector system 100 is used for scanning a beam of electrons across a specimen having a unit cell structure, such as a strontium titanate crystal structure, using a raster scanning pattern. The rows in Figure 2b show the images constructed with different flyback times (the target time/speed at which the beam is intended to move from the end of one scan line to the start of the next scan line) - specifically, images with flyback times of 1 ms, 100 µs, 20 µs and 0 µs (e.g. a theoretically instant change in position) are shown. It is clear that, using the deflector system 100, increasing the overall scanning speed (by decreasing the flyback time) produces increased warping and strain artifacts on the left side of the images, with the unit cell being increasingly compressed. Further details of these effects can be found in *"*Using Your Beam Efficiently: Reducing Electron Dose in the STEM via Flyback Compensation" (T. Mullarkey et al., 2022, Microscopy and Microanalysis, 28(4), 1428-1436).

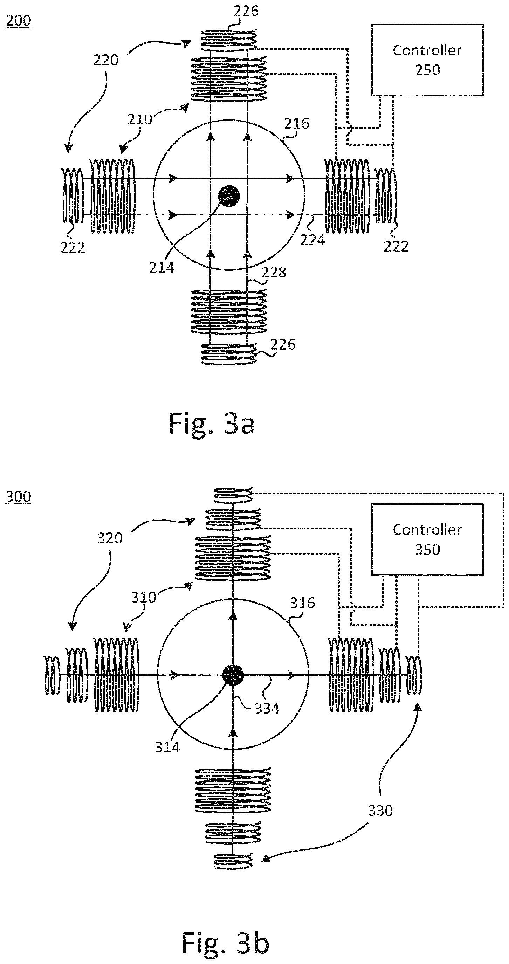

Figures 3a-3b illustrate deflector systems 200, 300 designed to overcome these drawbacks. As shown in Figure 3a, similarly to the deflector system 100, the deflector system 200 includes a first deflector set 210 comprising two pairs of coupled coils that are each configured generate electromagnetic fields therebetween in response to a driving input, and which are positioned such that the first deflector set 210 generates a first electromagnetic field (not shown). For example, when the system 200 is positioned adjacent or around a beam column 216, the first deflector set 210 is configured to deflect a beam 214 of charged particles passing between the coils.

The deflector system 200 also includes a second deflector set 220 which comprises a first pair of coils 222 that are coupled and configured to generate an electromagnetic field 224 therebetween, and a second pair of coils 226 that are coupled and configured to generate an electromagnetic field 228 therebetween in response to a driving input. In use, the coil pairs 226, 228 are positioned (e.g. substantially coincident or coplanar) such that the second deflector set 220 generates a second electromagnetic field across the beam column 216 and/or beam path. When the first and second deflector sets 210, 220 are driven at the same time, the respective first and second electromagnetic fields combine to produce a net field across an opening formed between the deflector sets 210, 220. In use, the deflector system 200 is positioned such that a beam 214 of charged particles passes through the opening.

The coils of the first deflector set 210 are generally more powerful and capable of producing larger beam deflections (e.g. larger deflection angles) than the coils of the second deflector set 220. In particular, the first deflector set 210 is capable of generating a stronger electromagnetic field than the second deflector set 220. For example, the first deflector set 210 can include wire coils that each have a greater number of turns than corresponding coils of the second deflector set 220. This means that the first deflector set 210 is capable of producing greater deflections than the second deflector set 220, but also has a larger inductance.

In one example, the first deflector set 210 includes two pairs of wire coils (e.g. one pair for "x-axis" deflections, another pair for "y-axis" deflections), where each coil has at least around 10 turns or at least around 12 turns, for example around 14 turns. In this example, the second deflector set 220 also includes two pairs of wire coils (e.g. one pair for "x-axis" deflections, another pair for "y-axis" deflections), each coil having no more than around 10 turns or no more than around 8 turns, for example around 7 turns or 5 turns. Additionally or alternatively, a ratio of the number of turns of the coils of the first deflector set 210 to the number of turns of the coils of the second deflector set 220 is preferably greater than 1, for example at least around 2 or at least around 5. In some examples, this ratio may be around 10. Accordingly, in this example the ratio of the (effective total) inductance of the first deflector set 210 to the (effective total) inductance of the second deflector set 220 is preferably greater than 1, for example at least around 2 or at least around 4 or 5, e.g. around 10.

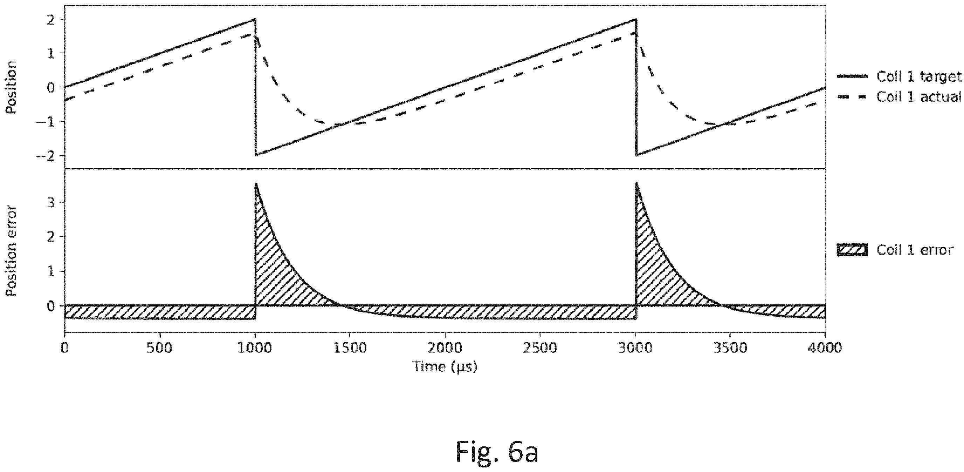

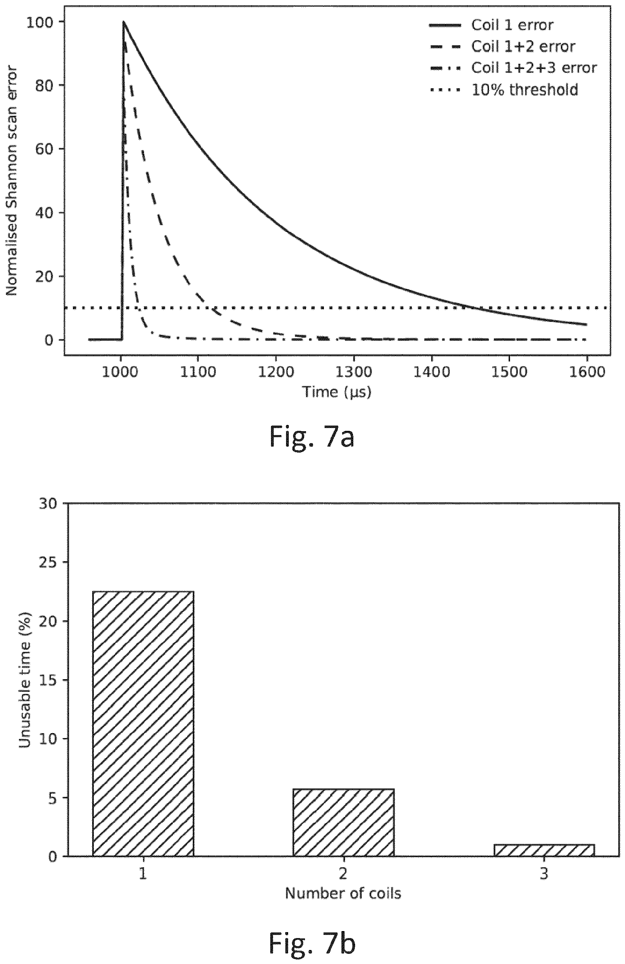

By virtue of the deflector sets 210, 220 having different deflection capabilities (e.g. different powers, inductances and/or numbers of coil turns), the deflector sets respond to driving input signals with different response rates or response profiles. The terms "response rate" and "response profile" refer to speed and/or manner in which one or more coil pairs of a deflector set generate an output field (for deflecting a beam of charged particles) in response to an input signal. For example, the input signal can have a profile that corresponds to a desired motion or scanning pattern (e.g. for scanning a beam across a target area), and the response rate of the deflector set is indicative of how quickly and/or accurately the deflector set is able to realise this beam motion by generating an output field. In this example, the first deflector set 210 has a slower response rate than the second deflector set 220, meaning the second deflector set 220 is capable of responding to input driving signals more quickly. The response rates of different deflector sets are discussed in more detail below with reference to Figures 6a-6c and 7a-7b.

In other examples, the deflector sets 210, 220 may have coils with the same (or similar) deflection capabilities and/or response rates. For example, the coils of the deflector sets 210, 220 may have the same or similar numbers of turns or inductances. In such an example, the second deflector set is driven using around half the current as for the first deflector set (the second deflector set input profile is around half the magnitude of that for the first set). The overall scanning performance (e.g. overall response rate) of the deflector system would also be improved in this situation.

In the example of Figure 3a, the first and second deflector sets 210, 220 of the deflector system 200 are arranged to be substantially coplanar such that the electromagnetic fields generated by each deflector set coincide and combine to produce an overall field. Accordingly, when a beam 214 of charged particles passes between the deflector sets, the beam 214 experiences a force vector due the combined magnetic field of the deflector sets, meaning the magnitude and direction of the overall field generated by the deflector sets 210, 220 can be controlled to deflect the beam 214 in any direction (e.g. in an x-y plane).

The deflector system 200 also includes a controller 250 for controlling the deflector sets. The controller 250 is communicably coupled to the first and second deflector sets 210, 220 and is configured to drive their coils with separate input signals in order to generate an electromagnetic field for deflecting a beam of charged particles. In Figure 3a, communication connections are shown between the controller 250 and coils of the first and second deflector sets 210, 220, although these are schematic and the actual configuration of hardware connections between the controller and the coils may vary.

In particular, the controller 250 is configured to drive the first and second deflector sets at least partially simultaneously. For example, the controller 250 provides driving signals to the deflector sets such that the first deflector set 210 is driven for a driving time period and the second deflector set 220 is driven for at least part of that driving time period. Accordingly, the two deflector sets 210, 220 can be driven independently yet at the same time. As explained in more detail below, this produces a net magnetic field that, as a result of using the two deflector sets simultaneously, has greater strength and a faster response rate than either of the individual magnetic fields produced by each deflector set. This allows for adaptive and dynamic control of beam deflection, which can enable faster scanning over larger fields-of-view and at lower magnifications.

Another example deflector system 300 is shown in Figure 3b. Similarly to the deflector system 200 shown in Figure 3a, the deflector system 300 includes a first deflector set 310 and a second deflector set 320 configured to produce respectively first and second electromagnetic fields across an opening therebetween (not shown), e.g. across a beam column 316 and/or beam path. In addition, the deflector system 300 has a third deflector set 330, which includes two further pairs of wire coils that are coupled and configured to generate electromagnetic fields therebetween in response to driving inputs - in use, these fields combine to produce a third electromagnetic field 334 across an opening between the deflector sets. In use, the deflector system 300 is positioned such that a beam 314 of charged particles passes through the opening.

As for the deflector sets of the system 200, the coils of the first deflector set 310 of the deflector system 300 are generally more powerful and capable of producing larger beam deflections (e.g. larger deflection angles) than the coils of the second deflector set 320. In particular, the first deflector set 310 is capable of generating a stronger electromagnetic field than the second deflector set 320. For example, the first deflector set 310 can include wire coils that each have a greater number of turns than corresponding coils of the second deflector set 320. This means that the first deflector set 310 is capable of producing greater deflections than the second deflector set 320, but also has a larger inductance.

Similarly, the coils of the second deflector set 320 are generally more powerful and capable of producing larger beam deflections than the coils of the third deflector set 330. In particular, the second deflector set 320 is capable of generating a stronger electromagnetic field than the third deflector set 330, e.g. by having wire coils that have a greater number of turns than corresponding coils of the third deflector set 330. This means that the second deflector set 320 is capable of producing greater deflections than the third deflector set 330, but also has a larger inductance.

In one example, the first deflector set 310 includes two pairs of wire coils (e.g. one pair for "x-axis" deflections, another pair for "y-axis" deflections), where each coil has at least around 10 turns or at least around 12 turns, for example around 14 turns. In this example, the second deflector set 320 and third deflector set 330 also each include two pairs of wire coils (e.g. one pair for "x-axis" deflections, another pair for "y-axis" deflections). Each coil of the second deflector set 320 has no more than around 10 turns or no more than around 8 turns, for example around 7 turns or 5 turns. Each coil of the third deflector set 330 has no more than around 7 turns or no more than around 5 turns, for example around 3 turns. Additionally or alternatively, a ratio of the number of turns of the coils of the first deflector set 310 to the number of turns of the coils of the second deflector set 320 is preferably greater than 1, for example at least around 2 or at least around 5. In some examples, this ratio may be around 10. A ratio of the number of turns of the coils of the second deflector set 320 to the number of turns of the coils of the third deflector set 330 is preferably greater than 1, for example at least around 2 or at least around 5, e.g. around 10. Accordingly, in this example the ratio of the (effective total) inductance of the first deflector set 310 to the (effective total) inductance of the second deflector set 320 is preferably greater than 1, for example at least around 2 or at least around 4 or 5, e.g. around 10, and the ratio of the (effective total) inductance of the second deflector set 320 to the (effective total) inductance of the third deflector set 330 is preferably greater than 1, for example at least around 2 or at least around 5, e.g. around 10.

By virtue of the deflector sets 310, 320, 330 having different deflection capabilities (e.g. different powers, inductances and/or numbers of coil turns), the deflector sets respond to driving input signals with different response rates. In particular, the first deflector set 310 has a slower response rate than both the second deflector set 320 and the third deflector set 330, meaning the second and third deflector sets 320, 330 are capable of responding to input driving signals more quickly than the first deflector set 310. The second deflector set 320 also has a slower response rate than the third deflector set 330, such that the third deflector set 330 has a faster response to input driving signals than either of the first or second deflector sets 310, 320. The response rates of different deflector sets are discussed in more detail below with reference to Figures 6a-6c and 7a-7b.

In other examples, two or more of the deflector sets 310, 320, 330 may have coils with the same (or similar) deflection capabilities and/or response rates. For example, the coils of the second and third deflector sets 320, 330 may have the same or similar numbers of turns or inductances.

In the example of Figure 3b, the first, second and third deflector sets 310, 320, 330 of the deflector system 300 are arranged to be substantially coplanar such that the electromagnetic fields generated by each deflector set coincide and combine to produce an overall net field. Accordingly, when a beam 314 of charged particles passes between the deflector sets, the beam 314 experiences a force vector due the combined magnetic field of the deflector sets, meaning the magnitude and direction of the overall field generated by the deflector sets 310, 320, 330 can be controlled to deflect the beam 314 in any direction (e.g. in an x-y plane).

The deflector system 300 also includes a controller 350 for controlling the deflector sets. The controller 350 is communicably coupled to the first, second and third deflector sets 310, 320, 330 and is configured to drive their coils with separate input signals in order to generate an electromagnetic field for deflecting a beam of charged particles. In Figure 3b, communication connections are shown between the controller 350 and coils of the first, second and third deflector sets 310, 320, 330, although these are schematic and the actual configuration of hardware connections between the controller and the coils may vary.

In particular, the controller 350 is configured to drive any combination of the first, second and third deflector sets at least partially simultaneously. For example, the controller 350 provides driving signals to at least two of the deflector sets 310, 320, 330 such that at least one deflector set (e.g. the first deflector set 310 and/or second deflector set 320) is driven for a driving time period and at least one other deflector set (e.g. the second deflector set 320 and/or third deflector set 330) is driven for at least part of that driving time period. Accordingly, at least two, preferably all, of the three deflector sets 310, 320, 330 can be driven independently yet at the same time, meaning the respective first, second and/or third electromagnetic fields combine to produce a net field across the opening formed between the deflector sets 310, 320, 330. As a result of using at least two of the deflector sets simultaneously, this net field has greater strength and a faster response rate than the individual fields produced by each deflector set. This allows for adaptive and dynamic control of beam deflection, which can enable faster scanning over larger fields-of-view and at lower magnifications. When all three deflector sets 310, 320, 330 are driven simultaneously, the strength and response speed of the net field are even greater than when two deflector sets are used (e.g. as in the deflector system 200 of Figure 3a).

In other examples of the deflector systems 200, 300, the second and/or third deflector sets may include an electrostatic deflector (e.g. a pair of electrostatic deflector plates) in place of one or more of the coil pairs. The electrostatic deflector is configured to generate an electric field across the opening between the deflector sets for deflecting a beam of charged particles. Electrostatic deflectors are capable of generating electric fields with a response rate that are well suited for use in the second or third deflector sets - for example, deflector plates can achieve high response rates such that, when used in a second or third deflector set, the error of a first or primary deflector set can be compensated for effectively to provide fast beam scanning across a large scan area.

Any of the deflector systems described herein, such as the deflector systems 200, 300, may include one or more additional deflector sets to deflect beams of charged particles over even larger distances and at even faster response rates.

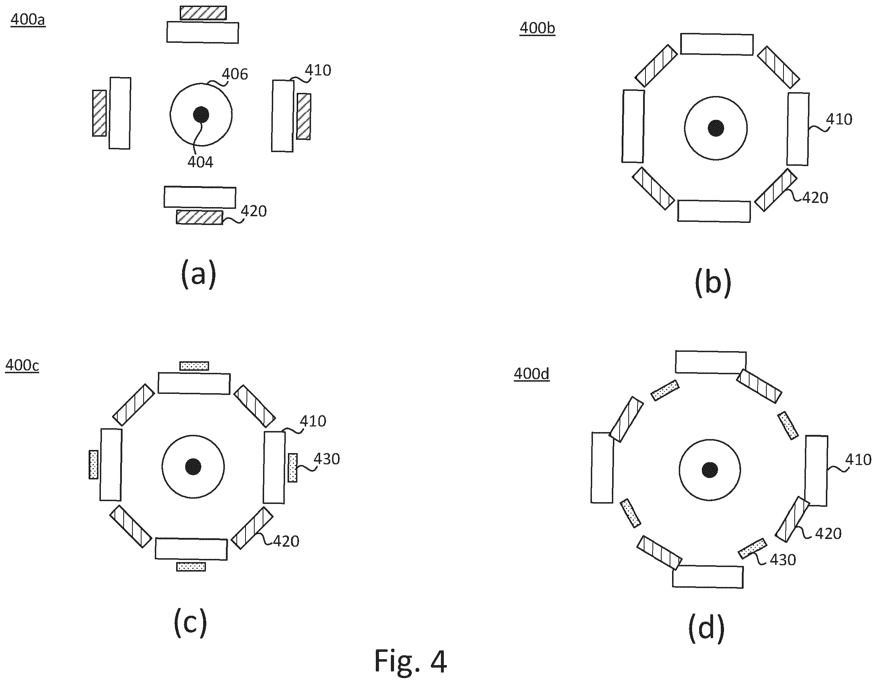

In the examples of Figures 3a-3b, the coils of the first, second and third deflector sets are shown aligned with respect to each other. However, in other examples, the coils of each deflector set may be angularly offset (around the opening formed between the deflector sets) from the coils of the other deflector sets. For example, the pairs of coils of a second (or third or additional) deflector set may be positioned at a location that is angularly offset or rotated from the positions of the coil pairs of the first deflector set, but still perpendicular to the other coil pair of that set. The angular offset between coil pairs of different deflector sets can be around 30° or 45°. Various example arrangements of deflector sets in deflector systems are illustrated in Figures 4a-4d. In these figures, a beam 404 of charged particles and a beam column 406 are shown passing through the deflector system for reference, but are not included as part of the deflector systems 400a-400d.

Figure 4a shows a deflector system 400a including a first deflector set 410 and a second deflector set 420. In some examples, the deflector system 400a corresponds to the deflector system 200 described above. The first and second deflector sets 410, 420 shown each include two pairs of coils, where the coil pairs of each deflector set are aligned perpendicularly around an opening, through which a beam 404 of charged particles and/or a beam column 406 (such as the beams 14, 14' and/or beam columns 16, 16' shown in Figures 1a-1b) can pass. In the arrangement of Figure 4a, the coil pairs of the second deflector set 420 are coincident or aligned (around the opening) with corresponding coil pairs of the first deflector set 410. This can simplify the construction and control of the deflector system 400a. In examples where there is a third and/or additional deflector set (e.g. as in the deflector system 300 of Figure 3b), the coil pairs of that deflector set may also be aligned with corresponding coil pairs of the first and second deflector sets 410, 420.

Figure 4b shows another deflector system 400b, also including a first deflector set 410 and a second deflector set 420. In some examples, the deflector system 400b corresponds to the deflector system 200 described above. Unlike the deflector system 400a shown in Figure 4a, the coil pairs of the second deflector set 420 are not coincident/aligned with the coil pairs of the first deflector set 410. In this example, the coil pairs of the second deflector set 420 are instead offset by 45° from the coil pairs of the first deflector set 410. Advantageously, this can enable the deflector system 400b to be more compact (e.g. having smaller bounding dimensions than the system 400a of Figure 4a). In other examples, the coil pairs of the second deflector set 420 may be offset by a different angle, such as 30°. In addition, angularly offsetting the coils or coil pairs of deflector sets (such as the examples of Figures 4b-4d) can avoid unintentional electromagnetic coupling (e.g. mutual inductance) between different deflector sets, thus improving the control of the deflector system.

Figure 4c shows another deflector system 400c, including a first deflector set 410, a second deflector set 420 and a third deflector set 430. In some examples, the deflector system 400c corresponds to the deflector system 300 described above. In the example shown in Figure 4c, the coil pairs of the second deflector set 420 are angularly offset from the coil pairs of the first deflector set 410, e.g. by 45° (like the deflector system 400b of Figure 4b) or 30°, and the coil pairs of the third deflector set 430 are aligned with corresponding coil pairs of the first deflector set 410. Alternatively, the coil pairs of the third deflector set 430 may be aligned with the (offset) coil pairs of the second deflector set 420, or the coil pairs of the first and second deflector sets 410, 420 may be aligned and the coil pairs of the third deflector set 430 may be angularly offset from those. Again, this can enable a more compact design for the deflector system.

Figure 4d shows a further deflector system 400d which also includes first, second and third deflector sets 410, 420, 430. In some examples, the deflector system 400d corresponds to the deflector system 300 described above. In the example shown in Figure 4d, the coil pairs of each deflector set are oriented at different angles around the opening for receiving a beam 404 and/or beam column 406. For example, as shown in Figure 4d, the coil pairs of the second deflector set 420 are angularly offset from the coil pairs of the first deflector set 410 by 30° clockwise, and the coil pairs of the third deflector set 430 are angularly offset from the coil pairs second deflector set 420 by a further 30° clockwise (equivalent to an angular offset of 60° clockwise from the coil pairs of the first deflector set 410). In this way, the coils of the different deflector sets 410, 420, 430 can be evenly distributed around the opening through which a beam 404 and/or beam column 406 may pass.

Where a deflector system is arranged with the coil pairs of different deflector sets angularly offset from one another (e.g. as in the examples of Figures 4b-4d), the controller of the deflector system can apply relevant scaling factors to the inputs for the coil pairs in order to account for the corresponding angular offsets of the electromagnetic fields generated by the coil pairs.

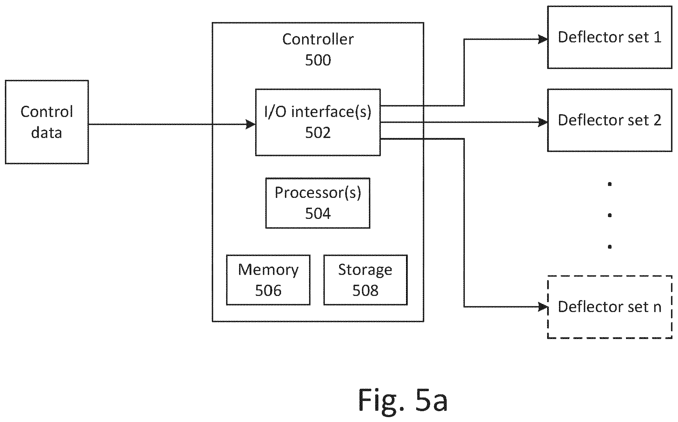

Figure 5a shows an example flow diagram for a controller 500 of a deflector system. In some examples, the controller 500 corresponds to a controller of any of the deflector systems 20, 20', 20", 200, 300, 400a-400d described above, such as controller 250 or 350. The controller 500 is configured to receive control data, for example from a user via a user interface, from a database and/or from one or more other processors. The controller 500 is also communicably coupled to at least two deflector sets, and is configured to output control signals for driving the deflector sets. The controller 500 includes a plurality of input and output (I/O) interfaces 502 for receiving the control data and for sending control signals to the deflector sets. The controller 500 also includes one or more processors 504, a volatile / random access memory 506 and persistent storage 508.

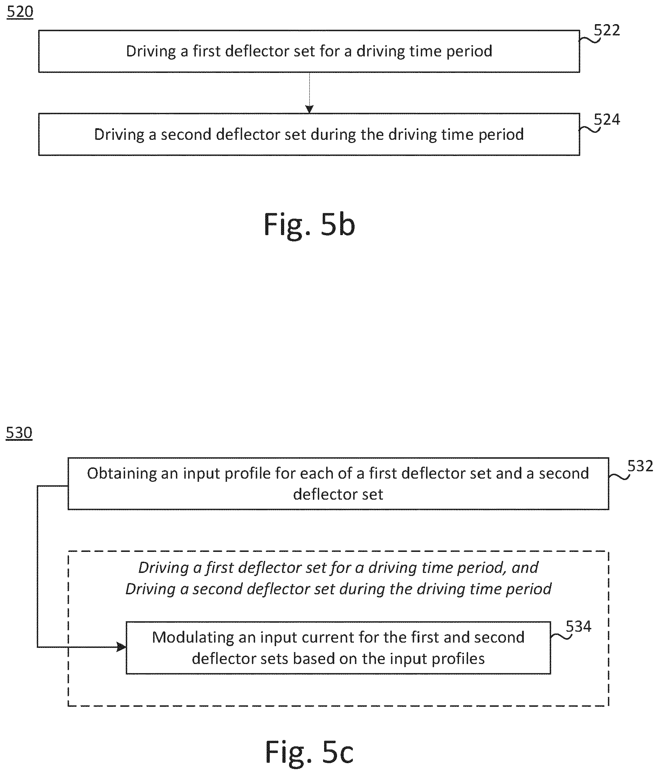

The control data is indicative of a target or desired motion pattern (e.g. scanning pattern) for a beam of charged particles. For example, the control data may be indicative of a raster scan or a serpentine pattern for scanning an electron beam across the surface of a specimen. The controller 500 uses this control data to send individual control signals to each deflector set. In some examples, the control data already includes separate instructions or control signals (input profiles) for each of the deflector sets, in which case the controller 500 sends corresponding signals to the deflector sets to modulate their input voltages / currents accordingly. In other examples, the control data is only indicative of a beam motion pattern, in which case the controller 500 additionally determines (using its one or more processors 504) an input profile for each deflector set based on the received control data, as described in more detail below with reference to Figures 5b, 6a-6c and 7a-7b.

Referring to Figures 5b-5e, methods for controlling a deflector system will now be described. In some examples, the methods are used to control any of the deflector systems 200, 300, 400a-400d or a deflector system of any of the instruments 10, 10' described above. In some examples, the methods are performed using a controller, such as the controller 500 of Figure 5a.

Figure 5b illustrates an example method 520 for controlling a deflector system, which includes driving, at step 522, a first deflector set (of a deflector system) for a driving time period, and driving, at step 524, a second deflector set (of the same deflector system) during the driving time period. Driving the deflector sets in this way can allow a beam of charged particles that is passing through the deflector system to be deflected by greater amounts and with greater response rates or speeds, in order to control the beam to move across a target area.

Driving the deflector sets generally involves activating or energising deflectors of the respective deflector sets in a dynamic and variable manner, e.g. from an already energised, activated or "on" state or from an un-energised, deactivated, disengaged or "off" state. There may be times during the driving time period when the second deflector set is not being driven, but at least a portion of the driving time period includes driving the first and second deflector sets simultaneously or concurrently.

Figure 5c illustrates another example method 530 for controlling a deflector system. The method 530 includes begins at step 532 with obtaining an input profile for each of a first deflector set and a second deflector set. At step 536, an input current or voltage for the first and second deflector sets are modulated based on the input profiles. In some examples, the modulating step 536 is performed as part of driving first and second deflector sets at least partially simultaneously during a driving time period (e.g. as per steps 522, 524 of method 520). For example, the input profiles can include data (e.g. waveform data) indicative of how the inputs (e.g. voltage/current levels) of the deflectors of the respective deflector sets are to be controlled. For example, in the case of a deflector set that comprises one or more pairs of scanning coils, the input profile for that deflector set may define a current or voltage profile (e.g. having a sawtooth pattern) with which to drive each coil pair. The input current(s) or voltage(s) of the deflector set are then modulated according to the obtained input profiles.

The first and second deflector sets are preferably different, for example in terms of deflective capability or inductance as described above. In this case, the input profile for the first and second deflectors would be different. For example, the input profile for a smaller and faster deflector set would be faster than the input profile for a larger and slower deflector set. A "faster" input profile is one which includes larger rates of change or gradient in the profile or signal. For example, a faster input profile may include larger average or maximum rates of change, or larger signal frequencies (e.g. base or maximum frequencies). This corresponds to the respective abilities of the deflector sets and their output response rates when controlled (by modulation) with such input profiles.

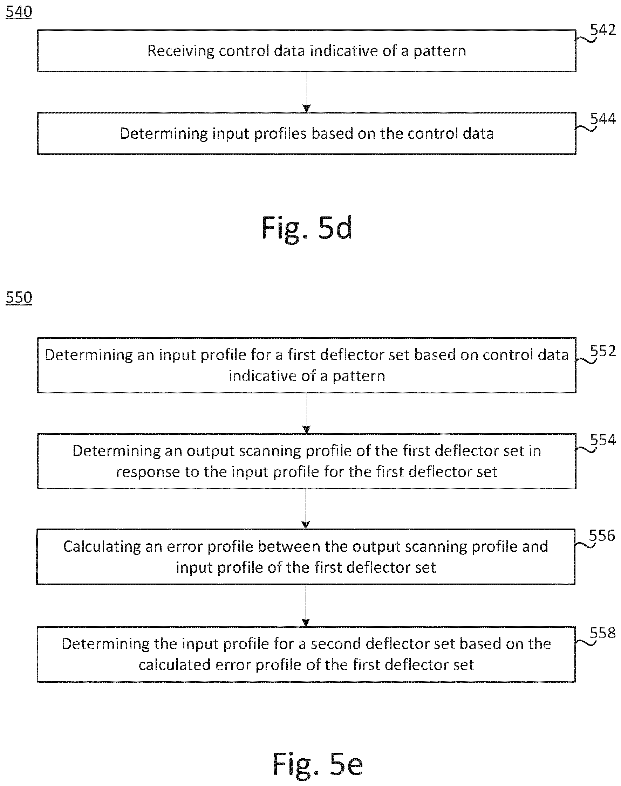

Figure 5d illustrates an example method 540 for obtaining input profile for first and second deflector sets. In some examples, the method 540 is performed as part of step 532 of method 530. The method 540 begins at step 542 by receiving control data indicative of a motion pattern or scanning pattern for moving or scanning a beam of charged particles across a target area. In some examples, the control data may indicate the target or desired pattern according to which the beam is to be moved. For instance, the control data may be indicative of a two-dimensional scanning pattern for the beam to trace at the target area, such as one or more of a raster pattern, a serpentine pattern, a spiral pattern, a square pattern, a round pattern, a sparse pattern, a (variable) vector pattern, a leapfrog scanning pattern, a Hilbert scanning pattern, or a Lissajous scanning pattern. For example, the control data can include a coordinate set corresponding to such a target pattern.

Once the control data is received, at step 544 input profiles for each of a first deflector set and a second deflector set are determined based on the control data. In some examples, the received control data may include separate data for the first and second deflector sets, in which case the input profiles for the deflector sets are determined based on the corresponding portions of the control data. In other examples, such as described above, the control data may simply indicate combined data, such as the desired overall pattern for moving or scanning the beam of charged particles. In this case, determining the input profiles for the deflector sets can involve decomposing the control data into separate control signals or input profiles for each deflector set. For example, this determination at step 544 (such as decomposing of control data) may be based on properties of the deflector sets, such as their deflection capabilities, response rates, inductances and/or number of turns. In one example, a scanning pattern profile may be decomposed into a slow-response input profile and a fast-response input profile, and these profiles may be assigned to the first and second deflector sets respectively. The input profiles determined at step 544 can then be used to modulate the inputs of (or otherwise drive) the deflector sets, thus deflecting a beam of charged particles in a time-varying manner in order to move across a target area according to the scanning or motion pattern.

Figure 5e illustrates an example method 550 for determining input profiles for a first deflector set and a second deflector set. In some examples, the method 550 is performed as part of step 544 of method 540. The method 550 begins at step 552, by determining an input profile for a first deflector set based on control data indicative of a scanning pattern. For example, the control data may be control data received as part of step 542 of method 540. In some examples, the control data includes an overall target profile corresponding to a target scanning or motion pattern. In some examples, the target profile is given as a set of coordinates. In other examples, the target profile is in the form of a motion or deflection over time in each direction or axis of motion, such as a target motion profile in an x-direction and a target motion profile in a y-direction. For example, if the target scanning pattern is a raster scanning pattern (in an x-y coordinate system), the target x-direction profile has a sawtooth shape (as per the example of Figures 6a-6c and 7a-7b described below), while the target y-direction profile is a series of discrete steps resembling a staircase shape. For other patterns, the target profiles may have different shapes.

Regardless of whether the control data includes separate profiles for different directions, or a single representation of the overall target pattern, the step 552 of can include using the profile(s) included in the control data as the input profile for the first deflector set. For example, if the control data includes a sawtooth and/or staircase profile, the input profile for the first deflector set can have a corresponding sawtooth and/or staircase shape. In one example, the control data can be used as the input profile for the first deflector set directly, such that the control data is used directly for modulating the input voltage(s)/current(s) of the first deflector set. Alternatively, the input profile for the first deflector set may be determined by analysing, scaling or otherwise modifying any profiles or shape information included in the control data. For example, where there are two or more deflector sets, an input profile for a first deflector set may be based on a scanning pattern profile (such as a sawtooth profile) but modified to anticipate discontinuities or sudden changes - e.g. for a sawtooth scanning pattern (for a raster scan pattern), the first deflector set may be driven with an input profile resembling the sawtooth scanning pattern but which anticipates or smoothens the abrupt change in position associated with line flyback, since the second or subsequent deflector sets may be controlled with faster response rates to achieve the sharp change in direction at the end of each scanning line.

The method 550 continues at step 554, where an output scanning profile of the first deflector set is determined. The output scanning profile is a profile indicating how the output of the first deflector set (e.g. its magnetic field output or deflection imparted to a beam of charged particles) varies over time in response to being driven with its determined input profile. For example, due to the finite inductance of electromagnetic deflectors, the deflector set will have an inductance-limited speed (or response rate) that may be less than a speed of the driving input profile, so the achieved scanning performance of the first deflector set may not exactly match the target input profile.

In one example, determining the output scanning profile of the first deflector set at step 554 can involve measuring an output scanning profile of the first deflector set. For example, the deflector system can include one or more sensors for measuring the electromagnetic field output by the first deflector set. In some examples, a second or further deflector set can be used as a sensor, wherein coils of the deflector set are configured to passively detect the electromagnetic field generated by the first deflector set. Based on an output signal generated by this second or further deflector set, the (magnetic field) output of the first deflector set can be determined. Thus, where the deflector system has two deflector sets, the second deflector set may be used to measure the output scanning profile of the first deflector set prior to determining the input profile for the second deflector set and then scanning using both deflector sets. Where the deflector system has three or more deflector sets, first and second deflector sets may be driven substantially simultaneously as described herein, while a third or further deflector set is used as a sensor to measure the live output of the first deflector set for determining its error profile and thus an input profile for the second deflector set in real time.

Additionally or alternatively, determining the output scanning profile of the first deflector set can include calculating, predicting and/or inferring the output scanning profile. For example, the output scanning profile may be predicted based on physical parameters (e.g. number of turns, coil material and/or physical arrangement of the deflectors) or using a model of the first deflector set, such as a machine learning model which is configured to infer an output scanning profile of the first deflector set for the input profile based on past output scanning performance data.

At step 556, an error profile between the output scanning profile of the first deflector set and the input profile for the first deflector set (or the target scanning profile) is calculated. In some examples, the error profile can be determined by calculating a difference between the output scanning profile of the first deflector set and the target scanning profile (e.g. a target sawtooth profile).

Then, at step 558, an input profile for a second deflector set is determined based on the calculated error profile of the first deflector set. This means that, when the method 550 is implemented with a deflector system, the second deflector set is driven using the error profile of the first deflector set. As explained in more detail below, this enables the second deflector set to compensate for deviations in the desired magnetic / deflection output of the first deflector set. For example, the (raw) error profile for the first deflector set can be used directly as the input profile for the second deflector set. In one example, an additive inverse of the error profile (i.e. positive signals become negative, and vice versa) is used as the input profile for the second deflector set.

In examples where a deflector system has one or more additional (e.g. third) deflector sets, steps 554-558 may be repeated based on the combined performance of the first and second deflector sets, and so on. For example, a combined output scanning profile of the first and second deflector sets in response to their respective input profiles is determined. Then, an error profile between the combined output scanning profile (for the first and second deflector sets) and the target scanning profile is determined, and that error profile is used for determining the input profile of a third deflector set in a similar fashion to the determination of the input profile for the second deflector set described above. Accordingly, the third deflector set (and subsequent deflector sets) can be driven using the combined scanning error of the previous (e.g. larger) deflector sets.

With reference to Figures 6a-6c and 7a-7b, an example control implementation of a deflector system will now be described. This example may correspond to the method 550 shown in Figure 5e. In this implementation, a deflector system having a first deflector set, a second deflector set and optionally a third deflector set is controlled to deflect a beam of charged particles (e.g. electrons or ions) according to a raster scanning pattern. The deflector sets each include two pairs of electromagnetic scanning coils with a finite inductance, although the plots of Figures 6a-6c and 7a-7b demonstrate to the performance of these deflector sets with respect to a single direction (e.g. an x-direction) and thus corresponding coil pairs, but the principles described apply equally to other deflection directions and coil pairs. In these examples, the scanning coils of the first deflector set have 14 turns, the scanning coils of the second deflector set have 7 turns, and the scanning coils of the third deflector set have 3 turns, and the inductances of the coils are scaled appropriately. In particular, these values lead to a set of inductances in the ratio of 196:49:9. As the response time constants of the coils scale proportionally with inductance, this leads to coil speeds in the ratio of approximately 20:5:1.

Figures 6a-6c show the response of the coils of each deflector set to a time-varying sawtooth scanning pattern or driving profile. The upper plot in Figure 6a shows a desired target sawtooth profile ("Coil 1 target") of a fast-scan direction (e.g. x-direction), and the output profile ("Coil 1 actual") consequently realised by the first deflector set (comprising scanning coils having 14 turns) when driven using the target profile as input. The realised or actual profile differs from the target sawtooth profile due to the finite inductance of the wire coils in the first deflector set. In some examples, the profiles shown in the upper plot of Figure 6a correspond to the input and output profiles determined at steps 552 and 554 of the method 550 described above.

The desired sawtooth profile includes a repeated pattern of a steady motion from a position of -2 to +2, and then an instantaneous return to the start position at -2. The scale of the position axis in these plots can vary depending on the magnification and/or size of specimen being scanned - for example, the range from -2 to +2 on the plots of Figures 6a-6c could correspond to a field-of-view of at least around 1 nm, at least around 100 nm, at least around 1 mm, no greater than around 10 mm, and/or no greater than around 5 mm. The range of magnification factors used for scanning/imaging can range from around 50,000 to around 50,000,000, or from around 100,000 to around 10,000,000. The sawtooth pattern shown in this example is for scanning across a scan line in a time of around 2000 µs, and depending on the number of pixels or lines being captured, can be used to achieve imaging frame rates of at least around 15 frames per second, or at least around 25 frames per second. However, this control implementation may be used for scanning with a variety of line scan times, image sizes, pixel sizes and magnifications at similar frame rates. As explained in more detail below, when the deflector system is controlled in the manner described, these frame rates can be achieved across substantially the entire range of magnifications available for a given charged-particle instrument.

The difference between the target profile and the actual profile is shown in the lower plot of Figure 6a. This plot demonstrates that by using only a single set of deflectors (e.g. coils), the target scanning pattern cannot be achieved perfectly, and there is a greater deviation between the actual and target profiles at the start of each new scan line due to the coils' inability to respond fast enough to the target step changes in the sawtooth profile. In some examples, this error profile corresponds to the error profile determined at step 556 of the method 550 described above. For instance, the upper plot in Figure 6a shows that the first deflector set has a slow response rate, since it takes at least around 500 µs for the first deflector set to respond to the step changes in the desired target profile ("Coil 1 target") of Figure 6a.

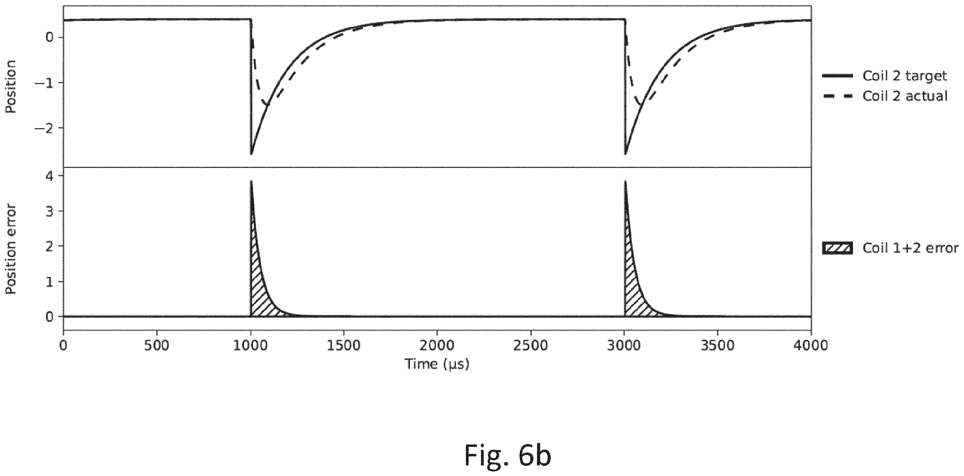

The upper plot in Figure 6b shows a target input profile ("Coil 2 target") for a second deflector set (comprising scanning coils having 7 turns) and the actual output profile ("Coil 2 actual") achieved by the second deflector set when driven using that target input profile. The input profile for the second deflector set is based on the error profile for the first deflector set (as shown in the lower plot of Figure 6a), and in this example, is equal to the additive inverse (opposite) of the first deflector set's error profile. The dashed line in the upper plot of Figure 6b ("Coil 2 actual") shows that the second deflector set cannot perfectly follow the error signal of the first deflector set (since it is also speed limited), but can achieve faster responses to a step change (for line flybacks). This is due to the coils of the second deflector set having fewer turns, thus lower inductances and faster response rates, than the coils of the first deflector set. For instance, the upper plot in Figure 6b shows that the second deflector set has a faster response rate than the first deflector set, since it only takes around 125 µs for the second deflector set to respond to the step changes in the desired target profile ("Coil 2 target") of Figure 6b, and can achieve a steeper gradient (more rapid changes) in its output profile ("Coil 2 actual"). In some examples, the target input profile shown in the upper plot of Figure 6b corresponds to the input profile for the second deflector set determined at step 558 of the method 550 described above.

The lower plot of Figure 6b shows the difference or error profile ("Coil 1+2 error") between the combined output profile of the first and second deflector sets (when driven in harmony using the input profiles shown in the upper plots of Figures 6a and 6b) and the target sawtooth profile ("Coil 1 target" in this case). As in Figure 6a, the error profile in Figure 6b is greatest at the end of each scanning line (or when line flyback begins), e.g. at 1000 µs and 3000 µs in this example. However, as shown in the lower plot of Figure 6b, the errors when using both a first and second deflector set return to zero or decay more quickly than the errors in the corresponding plot in Figure 6a (for a single deflector set). Thus, by controlling a deflector system in this manner, the overall response rate of the system can be improved, meaning the motion of the deflected beam of charged particles (across the target area) can match the intended target motion profile (scanning pattern) more accurately.

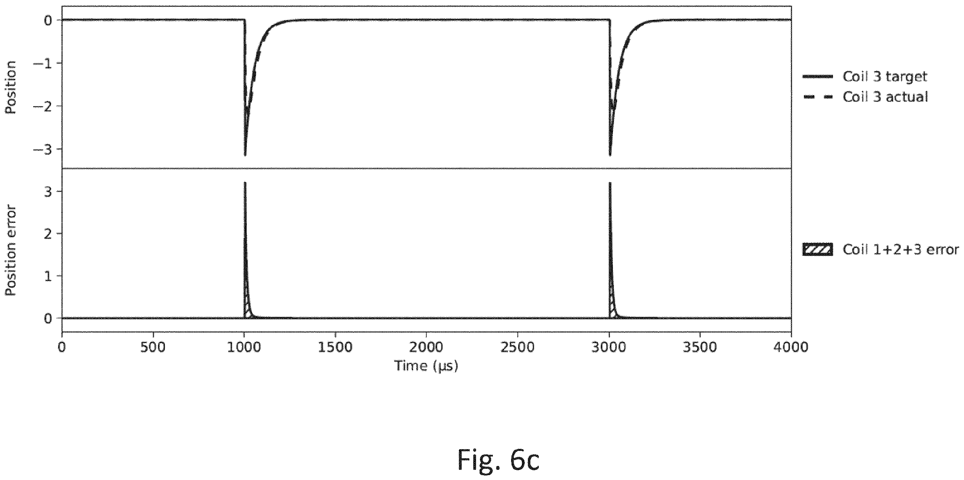

Figure 6c shows similar plots when using a third deflector set (comprising scanning coils having 3 turns) in combination with the first and second deflector sets. The upper plot in Figure 6c shows a target input profile ("Coil 3 target") for the third deflector set and the actual output profile ("Coil 3 actual") achieved by the third deflector set when driven using that target input profile. The input profile for the third deflector set is based on the error profile for the first and second deflector sets (as shown in the lower plot of Figure 6b), and in this example, is equal to the additive inverse (opposite) of the first and second deflector sets' error profile. The dashed line in the upper plot of Figure 6c ("Coil 3 actual") shows that the third deflector set can follow a fast input profile much more accurately than either of the first or second deflector sets. This is due to the coils of the third deflector set having fewer turns, thus lower inductances and faster response rates, than the coils of the first or second deflector sets. For instance, the upper plot in Figure 6c shows that the third deflector set has a faster response rate than either of the first or second deflector sets, since the differences between the achieved output profile ("Coil 3 actual") and its input profile ("Coil 3 target") are negligible, and the third deflector set can achieve a steeper gradient (more rapid changes) in its output profile ("Coil 3 actual") than either of the first or second deflector sets. In some examples, the target input profile shown in the upper plot of Figure 6c corresponds to the input profile determined at step 558 (when repeated for a third deflector set) of the method 550 described above.

The lower plot of Figure 6c shows the difference or error profile ("Coil 1+2+3 error") between the combined output profile of the first, second and third deflector sets (when driven using the input profiles shown in the upper plots of Figures 6a-6c) and the target sawtooth profile ("Coil 1 target" in this case). As in Figures 6a and 6b, the error profile in Figure 6c is greatest at the end of each scanning line (or when line flyback begins), but in contrast the residual errors last for much shorter periods of time, meaning the deflector system is able to realise the scanning pattern with yet further accuracy when using three deflector sets than when using two.

In the example of Figures 6a-6c, the first deflector set is shown being driven for a period of 4000 µs (see the upper plot of Figure 6a), which may be referred to as a driving time period. As shown in the upper plot of Figure 6b, the second deflector set is also driven throughout this driving time period of 4000 µs. However, since the first deflector is able eventually to match the target profile when scanning slowly across each line (albeit with a constant delay in this example), meaning there is little error to be corrected, in alternative examples the second deflector set may only be activated for a portion of the driving time period. For example, the second deflector set may only be driven or activated to improve the response rate of the overall system for line flybacks (or other sudden accelerations or changes in motion in a target scanning pattern). For example, this is the case for the third deflector set in the example of Figure 6c, which shows that the driving input profile for the third deflector set ("Coil 3 target") is zero for the majority of the driving time period. However, in other examples, the second or any subsequent deflector set can be driven at the same or different times during the driving time period, and/or for all or part of the driving time period.

As shown in Figures 6a-6c, the deflector sets having successively smaller coils are able to compensate for the deviations to the desired magnetic output of the previous deflector sets. This can be repeated for additional (e.g. four or more) deflector sets having yet smaller coils. Equally, these additional coils (or higher harmonic coils) can be arranged angularly offset from other coils, such as the arrangements shown in Figures 4a-4d, provided the vector sum of the combined magnetic output remains the same (as if the coils were arranged coincidently).

This approach allows for the full range of scanning coil strength and speed to be available across the whole range of operation of the instrument (e.g. microscope). The coils are driven independently from one another and their powers may be either opposing or enhancing the resultant magnetic vector, meaning beams of charged particles can be controlled in a dynamic, variable manner to improve the scanning performance of a deflector system.

Figure 7a is a plot of the scanning error for deflector systems employing one, two or three deflector sets. These error plots may correspond to the performance of the deflector system described with respect to Figures 6a-6c above. The plots in Figure 7a show the normalised errors between the achieved output profiles of three different deflector systems and a target profile corresponding to a line flyback in a raster scanning pattern, although the general improvements in performance described below will apply to other changes in scanning velocity for other scanning patterns. In this figure, the errors shown are normalised Shannon errors (relative positioning errors as a percentage of the width of the field of view), but any other type of error may be calculated between the output profile and target profile of these deflector systems.

The first error plot ("Coil 1 error") is that for a deflector system having a single deflector set of scanning coils that have 14 turns. As shown in Figure 7a, it takes around 500 µs for the error to fall below a 10% normalised error value. The second error plot ("Coil 1+2 error") is that for a deflector system having two deflector sets of scanning coils that have 14 turns and 7 turns respectively, and which drives the sets substantially simultaneously (as described above). It takes at least around 100 µs for the error to fall below a 10% normalised error value for this second system. The third error plot ("Coil 1+2+3 error") is that for a deflector system having three deflector sets of scanning coils that have 14 turns, 7 turns and 3 turns respectively. It takes less than around 50 µs for the error to fall below a 10% normalised error value for this third system. Therefore, for systems having two or more deflector sets which are driven substantially simultaneously (e.g. in the manners described above), the scanning response rate improves significantly (as shown by the progressively steeper gradients of the error plots).

For example, Figure 7b shows a plot of the fraction of a driving time period (or of a scanning time for a scanning pattern) where the output profile or position of the scanned beam is more than a threshold deviation from its intended location. Scanning deviations above the threshold deviation may be considered "unusable" due to the introduction of unacceptable errors (e.g. causing artifacts or warping as shown in Figure 2b), meaning a percentage of the driving time period can be calculated for which the overall error is greater than the threshold value. For example, this can correspond to the time in the plot of Figure 7a where the error is above the dashed line (shown at 10%). The threshold deviation may have a percentage value (a percentage with respect to a maximum possible error value) of at least around 1%, around 5% or 10%, or no more than around 15%.

As shown in Figure 7b, which is based on a 10% threshold deviation value, a deflector system having one deflector set (or one coil size) may be able to achieve a percentage of unusable scanning time of around 22.5%. In other words, with only one deflector set, and at fast scanning speeds, the beam may be unacceptably deviated for around 22.5% of the scanning or exposure time. This would mean that either a generated image of a specimen contains unacceptable strain artifacts or warping, or that the deflector system must wait for substantial settling times.

With the addition of a further deflector set (two sets in total), this percentage of unusable scanning time can drop to around 5.7% of unreliable exposure time, or a reduction in unusable time of around one quarter. Using an additional, third deflector set (three sets in total) can reduce the percentage of unusable time even further and by a similar amount, to around 1 % of unusable time. Equally, the percentage of usable time, or time where the output profile or position of the beam remains within the threshold deviation of the target scanning pattern or input profile, can be at least around 80%, at least around 90% or at least around 95% when two or more deflector sets are used, or at least around 97% or 99% when three or more deflector sets are used.

Therefore, by using two or more deflector sets in a coordinated manner, the image quality and/or overall scanning time can be improved. For low magnifications in particular, this means that the scanning rate or frame rate can be increased, allowing a substantially constant frame rate (such as at least around 15 frames per second, or at least around 25 frames per second) can be achieved across the full range of an instrument's magnification levels in a single mode of operation.

While specific instruments and deflector systems are shown, any appropriate combination of hardware may be employed. For example, any of the deflector systems 200, 300, 400a-d may be used as the deflector systems 20, 20', 20" of the instruments 10, 10' shown in Figures 1a-1b.

In some examples, the controller of an instrument or deflector system, or another computing component (such as a server), includes persistent storage that contains software and data for implementing the processes and functions described above, including but not limited to an operating system, a control module, a signal generation application and/or a database for storing received or computed driving profiles.

The above embodiments and examples are to be understood as illustrative examples. Further embodiments, aspects or examples are envisaged. It is to be understood that any feature described in relation to any one embodiment, aspect or example may be used alone, or in combination with other features described, and may also be used in combination with one or more features of any other of the embodiments, aspects or examples, or any combination of any other of the embodiments, aspects or examples. Furthermore, equivalents and modifications not described above may also be employed without departing from the scope of the invention, which is defined in the accompanying claims.

## Claims

1. A deflector system for a charged particle instrument, the system comprising:
a first deflector set configured to generate a first electromagnetic field for deflecting a beam of charged particles with a first response rate;
a second deflector set configured to generate a second electromagnetic field for deflecting the beam of charged particles with a second response rate; and
a controller configured to drive the first deflector set for a driving time period and drive the second deflector set during the driving time period to control the beam of charged particles to move across a target area.

2. The system of claim 1, wherein the controller is configured to drive the first and second deflector sets to scan the beam across the target area at a substantially constant frame rate, optionally at least 15 frames per second, for a range of magnifications between around 50,000 and 50,000,000; and/or
wherein the controller is configured to scan the beam such that a position of the beam remains within a 10% deviation of a target scanning pattern for at least 80% of the driving time period.

3. The system of claim 1 or 2, wherein the second response rate is greater than the first response rate, and/or wherein the first deflector set has a first inductance and the second deflector set has a second inductance that is lower than the first inductance.

4. The system of claim 3, wherein:
a ratio of the first inductance to the second inductance is at least around 2, preferably between 5 and 10; and/or
each of the first and second deflector sets comprise an electromagnetic deflector set comprising one or more, preferably two, pairs of scanning coils, wherein each coil of the first deflector set has a first number of turns and each coil of the second deflector set has a second number of turns that is less than the first number of turns.

5. The system of any preceding claim, further comprising at least one further deflector set configured to generate an additional electromagnetic field for deflecting the beam of charged particles with a response rate that is preferably greater than the first and second response rates;
optionally wherein the at least one further deflector set has an inductance which is less than an inductance of the first deflector set and/or the second deflector set, optionally wherein a ratio of the inductance of the second deflector set to the inductance of the further deflector set is at least around 2.

6. The system of any preceding claim, wherein each of the deflector sets have different inductances, and/or wherein at least one of the deflector sets comprises an electrostatic deflector set comprising one or more pairs of deflector plates.

7. The system of any preceding claim, wherein at least one of the deflector sets comprises an electromagnetic deflector set comprising one or more, preferably two, pairs of scanning coils, optionally wherein the pair(s) of scanning coils provide a beam opening therebetween for receiving the beam of charged particles and wherein each pair of scanning coils is arranged to generate an electromagnetic field across the beam opening.

8. The system of claim 7, wherein the pairs of coils for each deflector set are arranged substantially perpendicularly around the beam opening; and/or wherein each deflector set comprises an electromagnetic deflector set, and each pair of coils of the second deflector set is aligned with a corresponding pair of coils of the first deflector set or the coils of the second deflector set are angularly offset from the coils of the first deflector set, preferably by around 45°.

9. The system of any preceding claim, wherein the controller is configured to drive the deflector sets independently from one another, optionally with different input profiles; and/or wherein the controller is configured to scan the beam of charged particles across the target area according to a predetermined scanning pattern, optionally wherein the scanning pattern comprises a raster scanning pattern, a serpentine pattern, a spiral pattern, a square pattern, a round pattern, a Hilbert scanning pattern, a Lissajous scan and/or a sparse, vector and/or leapfrog scan coordinate set.

10. The system of any preceding claim, wherein the controller is further configured to:
receive control data indicative of a scanning pattern; and
modulate an input profile for each deflector set based on the control data to control the deflector sets to generate a combined electromagnetic field that deflects the beam across the target area according to the scanning pattern.

11. An instrument for imaging a specimen or for forming a pattern on a specimen, the instrument comprising one or more deflector systems according to any preceding claim, wherein the deflector system is configured to move a beam of charged particles across a target area comprising at least a portion of the specimen, optionally wherein the one or more deflector systems are configured to scan the beam across the target area at a rate of at least 15 frames per second.

12. A method for controlling a deflector system according to any of claims 1 to 10, comprising driving a first deflector set for a driving time period and driving a second deflector set during the driving time period to control a beam of charged particles to move across a target area.

13. The method of claim 12, further comprising the steps of:
obtaining an input profile for each of the first deflector set and the second deflector set; and
modulating an input current of the first and second deflector sets based on the input profiles;
optionally wherein the input profile for the second deflector set is faster than the input profile for the first deflector set for at least some of the driving time period.

14. The method of claim 13, wherein obtaining the input profiles comprises:
receiving control data indicative of a scanning pattern for scanning the beam across the target area; and
determining an input profile for each of the first deflector set and the second deflector set based on the control data;
wherein driving the first and second deflector sets comprises scanning the beam of charged particles across the target area according to the scanning pattern;
optionally wherein determining the input profiles for the first and second deflector sets is further based on inductances of the first and second deflector sets.

15. The method of claim 14, wherein determining the input profiles comprises:
determining the input profile for the first deflector set based on the control data indicative of the scanning pattern;
determining an output scanning profile of the first deflector set in response to the input profile for the first deflector set, optionally by measuring, calculating, predicting and/or inferring the output scanning profile of the first deflector set;
calculating an error profile between the output scanning profile of the first deflector set and the input profile for the first deflector set; and
determining the input profile for the second deflector set based on the calculated error profile;
optionally wherein the input profile for the second deflector set comprises an additive inverse of the error profile.
